# EUROPEAN PATENT SPECIFICATION

(11) **EP 4 628 342 B1**
(45) Date of publication and mention of the grant of the patent: **02.12.2026**
(21) Application number: 25159785.2
(22) Date of filing: 25.02.2025
(51) Int. Cl.: B60K 35/22, B60K 35/53, B60R 11/02, B60R 11/00

(54) **DISPLAY APPARATUS FOR VEHICLE AND DRIVING METHOD THEREFOR**
ANZEIGEVORRICHTUNG FÜR EIN FAHRZEUG UND ANSTEUERUNGSVERFAHREN DAFÜR
APPAREIL D'AFFICHAGE POUR VÉHICULE ET SON PROCÉDÉ DE COMMANDE

(30) Priority: 02.04.2024 KR 20240044872
(43) Date of publication of application: 08.10.2025
(73) Proprietor: Hyundai Mobis Co., Ltd., Gangnam-gu Seoul (KR)
(72) Inventor: JANG, Kil Pyung, 05837 Seoul (KR)
(74) Representative: Jung, Minkyu

(56) References cited:
- DE-B3- 102021 115 648
- DE-B4- 19 804 743

## Description

### CROSS-REFERENCE TO RELATED APPLICATIONS

This application claims the benefit of priority to Korean Patent Application No. 10-2024-0044872 filed in the Korean Intellectual Property Office on April 2, 2024.

### TECHNICAL FIELD

The present invention relates to a display apparatus for a vehicle.

### BACKGROUND

The description in this section merely provides background information related to the present disclosure and does not constitute the related art.

A display apparatus that may provide various pieces of information about a vehicle may be installed in the interior of the vehicle, such as the center fascia, dashboard, or head lining. This display apparatus may provide not only various pieces of information about a vehicle, but also various pieces of entertainment content. For example, the display apparatus may play music or videos, receive terrestrial broadcasting or satellite broadcasting and display the same on the screen, provide information for the convenience of a user, such as vehicle status, weather, and news, and perform navigation.

The display apparatus may be configured as a large screen to provide various pieces of information and various pieces of entertainment content. This display apparatus may also be installed on the dashboard of a vehicle disposed in front of a driver seat and a passenger seat.

Since the installation location of the fixed display apparatus is fixed, the space utilization inside a vehicle is limited, and the larger the display size, the lower the forward visibility.

The movable display apparatus may move up and down or left and right relative to the dashboard. The display moves along the guide, allowing a driver and a front passenger to selectively use the display apparatus.

Various dynamic display apparatuses are being released to improve user convenience. When the dynamic display apparatus moves to optimize space, the lower space may be used as a storage space. In the case of a pop-up display apparatus, the display apparatus stored in the storage space may be pulled out and used when necessary.

In the case of a pop-up display apparatus, the instrument panel (IP) garnish is separated from the display apparatus, which reduces the sense of design integration.

When the IP garnish is located at an upper end of the display apparatus, interference occurs with the IP garnish when the display apparatus moves upward, which causes restrictions on the cockpit design of an upper portion of the display apparatus, such as the IP garnish having to be located behind the display apparatus.

DE 198 04 743 B4 describes a retractable setting-up structure for a display which can set or place a display main body stably in both its lying state and its standing state, and can be operated by a simple mechanism, and can also be easily assembled. The structure includes a display connected to a moving block via pins, which are guided to move along a cam groove.

DE 10 2021 115648 B3 describes a size-adjustable display for a motor vehicle that can be operated with little wear. The display includes a screen carrier, which is designed to hold a screen, and comprises a first carrier section with a first inherent rigidity and a second carrier section with a second inherent rigidity that is reduced compared to the first inherent rigidity. The first and second carrier sections are glued or screwed together.

### SUMMARY

A main purpose of the invention is directed to providing a display apparatus for a vehicle capable of efficiently retracting or pulling out the display apparatus utilized in the vehicle from a storage space.

Another main purpose of the invention is directed to providing a display apparatus for a vehicle with a swing structure that eliminates interference between the display apparatus and IP garnish, thereby improving the freedom of vehicle cockpit design at an upper portion of the display apparatus.

The aspects of the present disclosure are not limited to those mentioned above, and other aspects not mentioned herein will be clearly understood by those skilled in the art from the following description. According to the present invention, a display apparatus and a method for driving the same are set forth in the independent claims.

According to an embodiment, the display apparatus for the vehicle can efficiently allow the display apparatus utilized in the vehicle to be retracted into or pulled out from the storage space.

According to an embodiment, the display apparatus for the vehicle can eliminate interference between the display apparatus and the IP garnish, thereby improving the degree of freedom of the vehicle cockpit design at an upper portion of the display apparatus.

### BRIEF DESCRIPTION OF THE DRAWINGS

FIG. 1 is a combined perspective view of a display apparatus for a vehicle according to an embodiment of the present disclosure.
FIG. 2 is an exploded perspective view of a display apparatus for a vehicle according to an embodiment of the present disclosure.
FIG. 3 is a view showing movement of a display apparatus for a vehicle along direction B-B' of FIG. 1 according to an embodiment of the present disclosure.
FIG. 4 is a view showing an operation example of a display apparatus for a vehicle along direction A-A' of FIG. 1 according to an embodiment of the present disclosure.
FIG. 5 is a cross-sectional view taken along line A-A' of FIG. 1 according to an embodiment of the present disclosure.
FIG. 6 is a flowchart showing a method of moving a display apparatus for a vehicle to an open state according to an embodiment of the present disclosure.
FIG. 7 is a flowchart showing a method of moving a display apparatus for a vehicle to a closed state according to an embodiment of the present disclosure.

### DETAILED DESCRIPTION

Hereinafter, some exemplary embodiments of the present disclosure will be described in detail with reference to the accompanying drawings. In the following description, like reference numerals preferably designate like elements, although the elements are shown in different drawings. Further, in the following description of some embodiments, a detailed description of known functions and configurations incorporated therein will be omitted for the purpose of clarity and for brevity.

Additionally, various terms such as first, second, A, B, (a), (b), etc., are used solely to differentiate one component from the other but not to imply or suggest the substances, order, or sequence of the components. Throughout this specification, when a part 'includes' or 'comprises' a component, the part is meant to further include other components, not to exclude thereof unless specifically stated to the contrary. The terms such as 'unit', 'module', and the like refer to one or more units for processing at least one function or operation, which may be implemented by hardware, software, or a combination thereof.

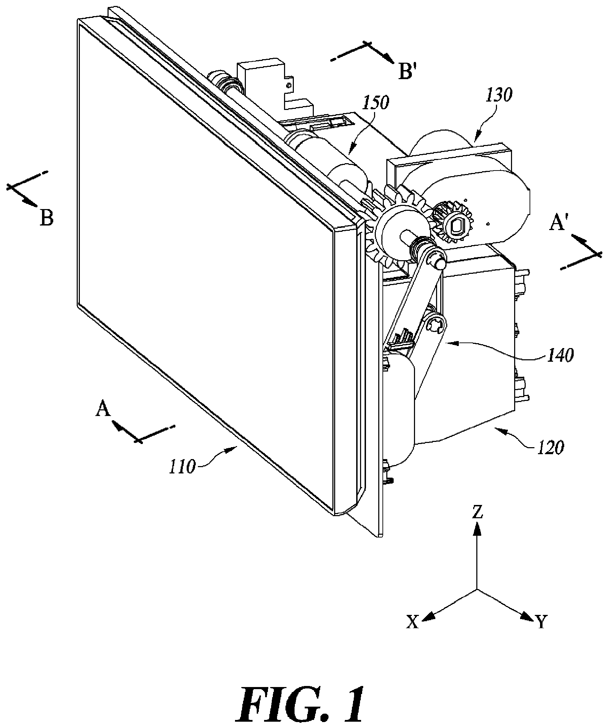

FIG. 1 is a combined perspective view of a display apparatus for a vehicle according to an embodiment of the present disclosure.

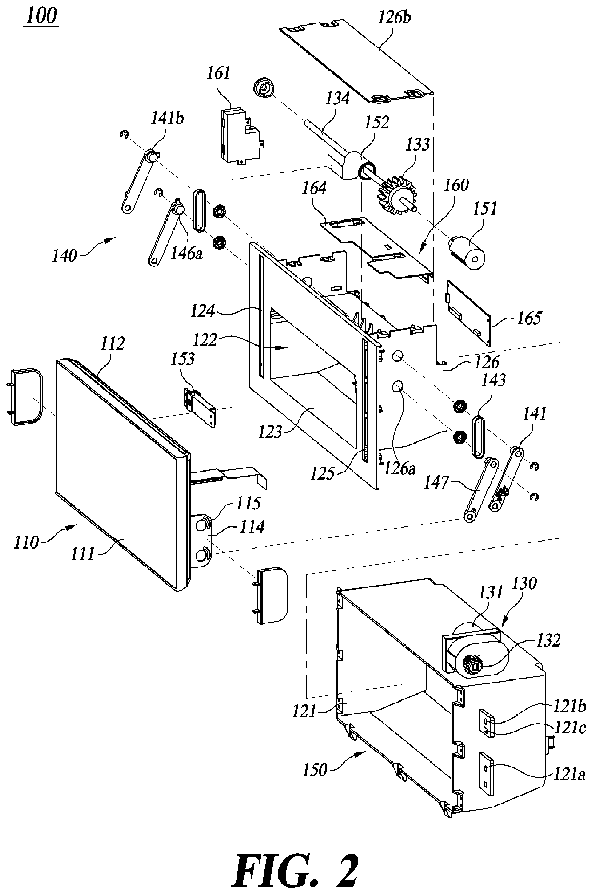

FIG. 2 is an exploded perspective view of a display apparatus for a vehicle according to an embodiment of the present disclosure.

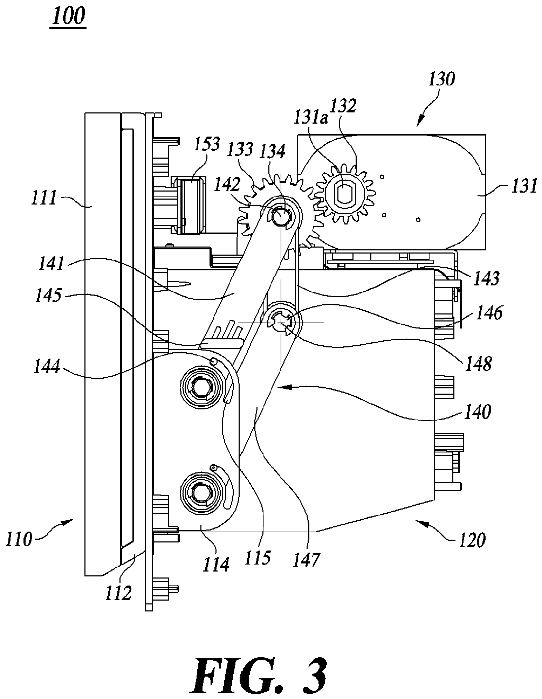

FIG. 3 is a view showing movement of a display apparatus for a vehicle along direction B-B' of FIG. 1 according to an embodiment of the present disclosure.

Referring to FIGS. 1 and 2, a display apparatus 100 for a vehicle includes all or part of a display module 110, a housing 120, a driving unit 130, a mover 140, and a controller 160.

A display panel 111 of the display module 110 may include a display apparatus, LCD, LED, OLED, POLED, or other known display, which may receive signals from the integrated control system of a vehicle and output various pieces of information on a screen.

The display module 110 includes all or part of the display panel 111 and a back cover 112.

The display panel 111 is disposed on the front surface of the display module 110 and outputs the screen or displays an image.

The back cover 112 covers the display panel 111 on a rear surface of the display module 110.

Referring to FIG. 3, a closed state in which the display module 110 is retracted into the housing 120 and an open state in which the display module 110 is pulled out from the housing 120 are illustrated.

When the display module 110 is in a closed state, at least one surface of the back cover 112 is disposed to face one surface of the housing 120. When the display module 110 is in an open state, at least a part of the back cover 112 may be exposed to the outside.

The back cover 112 includes a first heat dissipation opening 113 to release heat generated from the display panel 111.

A control arm bracket 114 connected to a mover 140 is disposed at both ends of one surface of the back cover 112. The end of the control arm bracket 114 is configured in a form that is bent inwardly of the back cover 112, and the end of the control arm bracket 114 passes through the back cover 112 and is coupled to the other surface of the back cover 112.

The housing 120 is disposed adjacent to or in contact with one surface of the display module 110 and forms a receiving (or accommodation) space therein.

The housing 120 includes a storage portion 122 that is disposed adjacent to or in contact with one surface of the display module 110 inside the housing 120 and includes a storage space 123 that is open on the outside at least in one area, and a casing 121 that is disposed on a rear surface of the storage portion 122 and covers the storage portion 122.

The storage portion 122 has a moving hole 124 that extends in a height direction of the display module 110 so that the mover 140 may move at both ends of one surface of the storage portion 122 that faces the display module 110.

The mover 140 rotates by passing through the moving hole 124, and the display module 110 coupled to the control arm bracket 114 swings. Herein, the swing movement means a movement in which the display module 110 moves at a certain angle around a longitudinal axis of a main shaft 134.

A dust guard 125 mounted on the moving hole 124 is inserted into the moving hole 124 and fitted, and prevents foreign substances from entering the housing 120 when the display module 110 is in a closed state.

The dust guard 125 is made of an elastic material, and a groove is formed on one surface of the dust guard 125 so that the mover 140 may move when the display module 110 is in an open state.

The storage space 123 is formed by extending from one surface of the storage portion 122 in the other direction, and the storage space 123 is formed apart from an upper end of the housing 120 in a height direction.

When the display module 110 is in a closed state, the display module 110 covers an opening of the storage space 123, so that the storage space 123 is closed, and when the display module 110 is in an open state, the storage space 123 is in an open state.

A storage portion bracket 126 is disposed on both sides of the storage portion 122. A through hole 126a is formed on one surface of the storage portion bracket 126 so that the mover 140 may pass through.

A storage portion upper bracket 126b is disposed on an upper end of the storage portion 122 to protect the driving unit 130 and the mover 140.

A control printed circuit board (PCB) 165 that controls a motor 131, a position sensor 161, and a display PCB 164 may be disposed in an area at an upper end or a rear surface of the storage space 123.

For vibration durability, at least four screw fasteners 121a, at least two clip fasteners 121b, and at least two locator fasteners 121c are formed on both sides of the casing 121 and are mountable to a vehicle cockpit. However, the positions and quantities of the screw fasteners 121a, the clip fasteners 121b, and the locator fasteners 121c may be changed in consideration of the weight of the display apparatus, cockpit conditions, etc.

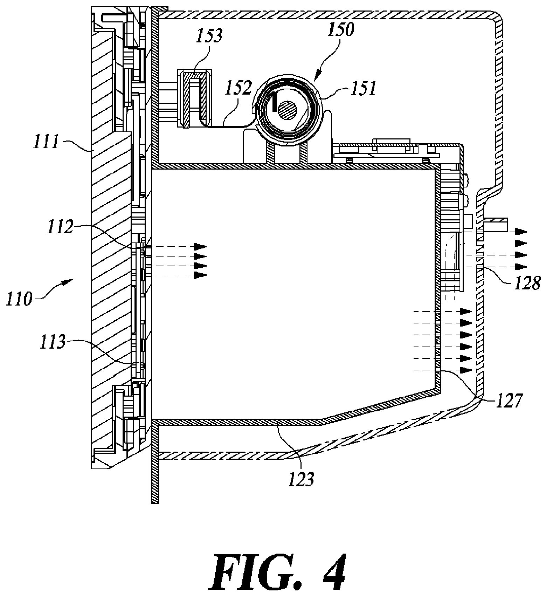

FIG. 4 is a view showing an operation example of a display apparatus for a vehicle along direction A-A' of FIG. 1 according to an embodiment of the present disclosure.

Referring to FIG. 4, the driving unit 130 may be disposed at an upper end of the storage space 123 adjacent to the mover 140.

The driving unit 130 includes all or part of the motor 131, a drive gear 132, a power gear 133, and the main shaft 134.

The motor 131 is driven by an open signal transmitted by the controller 160 and generates a driving force. The motor 131 stops driving by a close signal transmitted by the controller 160.

The drive gear 132 rotates in the direction of a motor shaft 131a and is connected to the motor 131.

The power gear 133 is disposed adjacent to the motor 131 and the drive gear 132 so as to rotate by the driving force transmitted from the motor 131 and the drive gear 132.

The main shaft 134 is coupled to the power gear 133 to rotate by the rotation of the power gear 133, and extends in an axial direction of the motor 131.

The main shaft 134 passes through the through hole 126a of each storage portion bracket 126 located on both sides of the storage portion 122.

The display module 110 may pivot and swing with respect to (or about) the longitudinal axis of the main shaft 134 according to the rotation of the main shaft 134.

The mover 140 includes all or part of a first control arm 141 disposed adjacent to the storage portion bracket 126, a second control arm 147, a driving belt 143, and a sub-shaft 146.

The first control arm 141 is connected between the control arm bracket 114 coupled to one surface of the display module 110 and the main shaft 134.

A main shaft through hole 141b passing through the main shaft 134 is formed on one side of the first control arm 141. The main shaft through hole 141b extends along the longitudinal direction of the main shaft 134. The first control arm 141 rotates with respect to (or around) a first rotation axis 142 by the rotation of the main shaft 134.

The second control arm 147 is connected between the control arm bracket 114 and the driving belt 143 coupled to the first control arm 141.

A sub-shaft through hole 146a through which a sub-shaft 146 passes is formed on one side of the second control arm 147. The sub-shaft 146 is fixed to the storage portion bracket 126 so that the second control arm 147 rotates.

The driving belt 143 connects between the main shaft through hole 141b and the sub-shaft through hole 146a.

The second control arm 147 rotates with respect to (or around) a second rotation axis 148 by transmitting a rotational force of the main shaft 134 by the driving belt 143.

The display module 110 swings around the longitudinal axis of the main shaft 134 by the rotation of the first control arm 141 and the second control arm 147.

The first control arm 141 includes a locking pin 144 formed on one surface of the first control arm 141 so as to adjust the rotation angle of the first control arm 141. The locking pin 144 may be formed on one surface of the second control arm 147.

The control arm bracket 114 has a guide hole 115a located at one area of one surface of the control arm bracket 114 that contacts the first control arm 141 to correspond to the rotation angle of the first control arm 141 so as to limit a movement of the locking pin 144.

The guide hole 115b located at one area of one surface of the control arm bracket 114 to correspond to the rotation angle of the second control arm 147 may be formed.

The first control arm 141 includes a support bar 145 formed on one surface of the first control arm 141 and disposed adjacent to the locking pin 144.

The support bar 145 prevents the rotation of the display module 110 by restricting the rotation of the control arm bracket 114 when the display module 110 is pulled out from the housing 120 and is in an open state.

When an external force is applied to the display module 110, the display module 110 does not rotate clockwise due to the support bar 145.

When an external force is applied to the display module 110, the display module 110 does not rotate counterclockwise due to the locking pin 144.

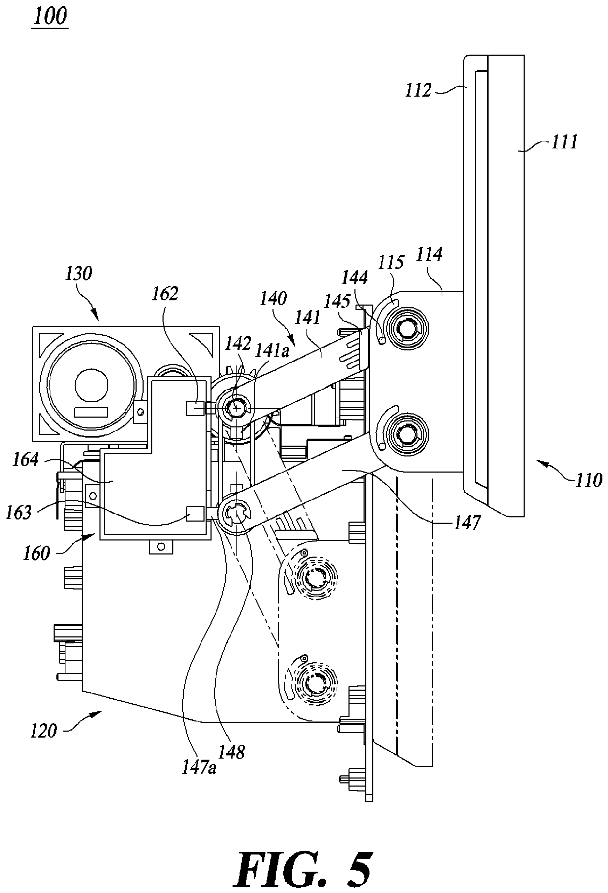

FIG. 5 is a cross-sectional view taken along line A-A' of FIG. 1 according to an embodiment of the present disclosure.

Referring to FIG. 5, an elastic member 150 is coupled to a mover 140 to provide an auxiliary force to the mover 140. The elastic member 150 includes all or part of a first spring holder 151, a second spring holder 153, and a spiral spring 152.

The first spring holder 151 is disposed at an upper end of the storage space 123 and is coupled to the main shaft 134. The spiral spring 152 that rotates together with the main shaft 134 is mounted inside the first spring holder 151.

The second spring holder 153 is fixed to an upper end of the storage space 123, and the spiral spring 152 retracted into the first spring holder 151 is connected and fixed inside the second spring holder 153.

When the display module 110 is in a closed state, a second heat dissipation opening 127 is formed in an area at a rear surface of the storage space 123 of the storage portion 122 to release heat. The second heat dissipation opening 127 is disposed to correspond to the first heat dissipation opening 113.

A third heat dissipation opening 128 is formed in an area at a rear surface of the casing 121 to release heat to the outside. The third heat dissipation opening 128 is disposed to correspond to the second heat dissipation opening 127.

A flow path is formed to allow air to flow through the first heat dissipation opening 113, the second heat dissipation opening 127, and the third heat dissipation opening 128 inside the display apparatus 100 for the vehicle.

Referring to FIG. 3, the controller 160 controls the mover 140 and the driving unit 130 to control the movement of the display module 110.

The position sensor 161 transmits a signal to the controller 160 that controls the operation of the driving unit 130 according to the movement of the mover 140.

The position sensor 161 includes all or part of a switch a (or first switch) 162, a switch b (or second switch) 163, and a position circuit board 163.

The position sensor 161 is disposed on one surface of the storage portion bracket 126 and is disposed adjacent to the first control arm 141 and the second control arm 147.

The switch a 162 is configured to be in contact with a first contact protrusion 141a formed on one end of the longitudinal direction of the first control arm 141, and is disposed adjacent to the first rotation axis 142 on one surface of the position sensor 161.

When the display module 110 is in a closed state, the first contact protrusion 141a is disposed at a position in contact with the switch a 162. When the display module 110 is in an open state, the first contact protrusion 141a rotates counterclockwise at the switch a 162 corresponding to the angle at which the first control arm 141 rotates. In other words, when the display module 110 is in an open state, the first contact protrusion 141a does not contact the switch a 162.

The switch b 163 is configured to be in contact with a second contact protrusion 147a formed on one end of the longitudinal direction of the second control arm 147, and is disposed adjacent to the second rotation shaft 148 on one surface of the position sensor 161.

When the display module 110 is in a closed state, the second contact protrusion 147a is disposed to face the longitudinal direction of the driving belt 143. In other words, when the display module 110 is in a closed state, the second contact protrusion 147a does not contact the switch b 163. When the display module 110 is in an open state, the second contact protrusion 147a contacts the switch b 163.

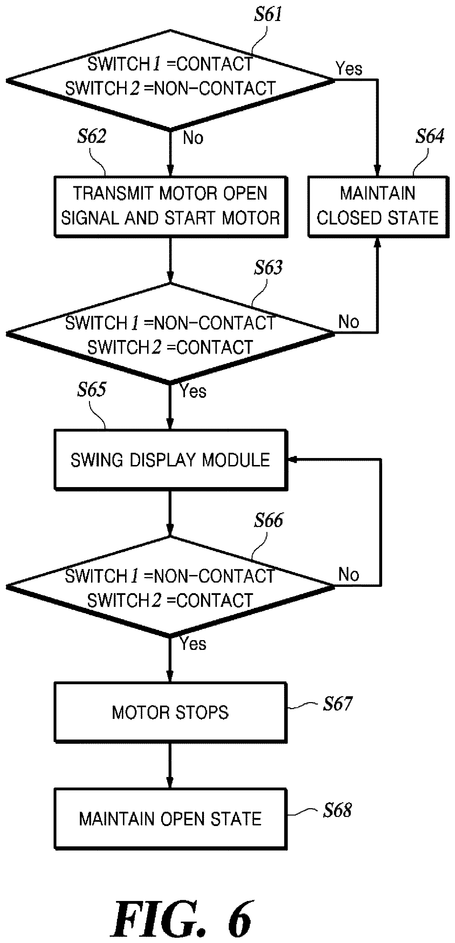

FIG. 6 is a flowchart showing a method of moving a display apparatus for a vehicle to an open state according to an embodiment of the present disclosure.

Referring to FIG. 6, the position sensor 161 senses whether the first contact protrusion 141a contacts the switch a 162 and the switch a 162 is turned on, and whether the second contact protrusion 147a does not contact the switch b 163 and the switch b 163 is turned off (S61).

When the first contact protrusion 141a contacts the switch a 162 and the switch a 162 is turned on, and the second contact protrusion 147a does not contact the switch b 163 and the switch b 163 is turned off, the motor 131 is not driven and the display module 110 is maintained in a closed state (S64).

When an open signal is transmitted to the motor 131 by the controller 160, the motor 131 is driven to rotate the first control arm 141 and the second control arm 147 (S62). In this connection, the first contact protrusion 141a does not contact the switch a 162, so that the switch a 162 is turned off, and the second contact protrusion 147a does not contact the switch b 163, so that the switch b 163 is also turned off (S63). In other words, the display module 110 swings in the direction of being pulled out from the housing 120 (S65).

When the first contact protrusion 141a does not contact the switch a 162, so that the switch a 162 is in an off state, and the second contact protrusion 147a contacts the switch b 163, so that the switch b 163 is in an on state, the position sensor 161 transmits a stop signal to the controller 160 (S66). The controller 160 stops driving the motor 131 (S67). In other words, the display module 110 maintains the open state (S68).

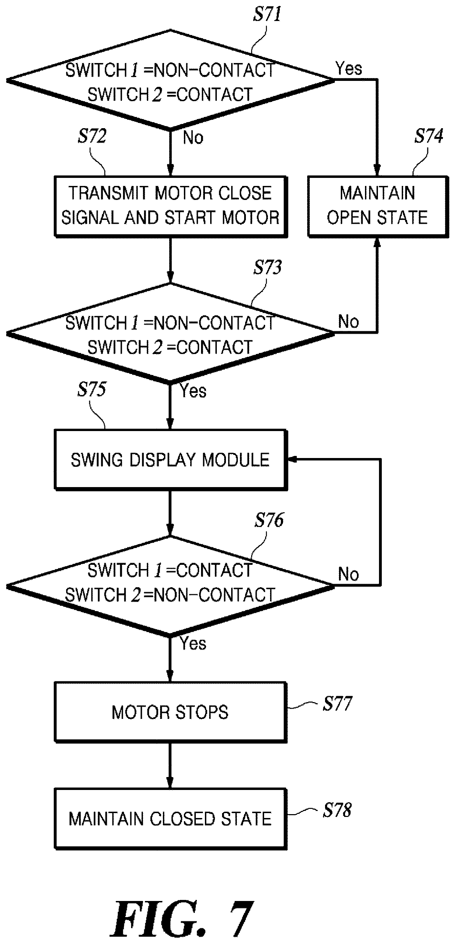

FIG. 7 is a flowchart showing a method of moving a display apparatus for a vehicle to a closed state according to an embodiment of the present disclosure.

Referring to FIG. 7, the position sensor 161 senses whether the first contact protrusion 141a does not contact the switch a 162 so that the switch a 162 is in an off state, and whether the second contact protrusion 147a contacts the switch b 163 so that the switch b 163 is in an on state (S71).

When the first contact protrusion 141a does not contact the switch a 162 so that the switch a 162 is in an off state, and the second contact protrusion 147a contacts the switch b 163 so that the switch b 163 is in an on state, the motor 131 is not driven and the display module 110 maintains the open state (S74).

When a close signal is transmitted to the motor 131 by the controller 160, the motor 131 is driven to rotate the first control arm 141 and the second control arm 147 (S72). In this connection, the first contact protrusion 141a does not contact the switch a 162, so that the switch a 162 is turned off, and the second contact protrusion 147a does not contact the switch b 163, so that the switch b 163 is also turned off (S73). In other words, the display module 110 swings in the direction of being retracted into the housing 120 (S75).

When the first contact protrusion 141a of the position sensor contacts the switch a 162 and the switch a 162 is turned on, and the second contact protrusion 147a does not contact the switch b 163 and the switch b 163 is turned off, the position sensor 161 transmits a stop signal to the controller 160 (S76). The controller 160 stops driving the motor 131 (S77). In other words, the display module 110 maintains a closed state (S78).

Although exemplary embodiments of the present disclosure have been described for illustrative purposes, those skilled in the art will appreciate that various modifications, additions, and substitutions are possible, within scope of the claimed invention defined by the claims. Therefore, exemplary embodiments of the present disclosure have been described for the sake of brevity and clarity. The scope of the invention is not limited by the illustrations. Accordingly, one of ordinary skill would understand that the scope of the claimed invention is not to be limited by the above explicitly described embodiments but by the appended claims.

## Claims

1. A display apparatus (100) for a vehicle, comprising:
a display module (110) comprising a display panel (111) configured to display an image;
a housing (120) disposed adjacent to the display module (110) and having an accommodation space;
a mover (140) connected to and configured to move the display module (110);
a driving unit (130) disposed at the accommodation space of the housing (120) and configured to provide a driving force to the mover (140); and
a controller (160) configured to control the mover (140) and the driving unit (130),
wherein the driving unit (130) comprises:
a motor (131) disposed adjacent to the mover (140) and configured to generate the driving force;
a power gear (133) disposed adjacent to the motor (131) and configured to rotate when the driving force is transmitted from the motor (131); and
a main shaft (134) coupled to the power gear (133) and configured to rotate when the power gear (133) rotates,
wherein the display module (110) is configured to pivot and swing with respect to a longitudinal axis of the main shaft (134) when the main shaft (134) rotates,
**characterized in that**
the mover (140) comprises:
a first control arm (141) connected between a control arm bracket (114) coupled to the display module (110) and the main shaft (134), and configured to rotate with respect to a first rotation axis when the main shaft (134) rotates; and
a second control arm (147) connected between the control arm bracket (114) and a driving belt (143) coupled to the first control arm (141), and configured to rotate with respect to a second rotation axis when a rotational force of the main shaft (134) is transmitted to the driving belt (143),
wherein the display module (110) is configured to swing with respect to the longitudinal axis of the main shaft (134) when the first control arm (141) and the second control arm (147) rotates.

2. The display apparatus (100) of claim 1, wherein:
the housing (120) comprises a storage portion (122) disposed adjacent to the display module (110) and having a storage space (123) and an opening exposing the storage space (123) externally of the housing (120),
the storage portion (122) has a moving hole at a surface of the storage portion (122) facing the display module (110) and extending in a height direction of the display module (110) to allow the mover (140) to move, and
the storage space (123) extends in a direction different from the height direction of the display module (110), and is spaced apart from an upper end portion of the housing (120) in the height direction.

3. The display apparatus (100) of claim 2, wherein:
the display module (110) has a first heat dissipation opening (113),
the storage portion (122) has a second heat dissipation opening (127) at a rear surface of the storage space (123) of the storage portion (122), the second heat dissipation opening (127) disposed corresponding to the first heat dissipation opening (113),
the housing (120) has a third heat dissipation opening (128) at a rear surface of the housing (120), the third heat dissipation opening (128) disposed corresponding to the second heat dissipation opening (127), and
an air flow path extends through the first heat dissipation opening (113), the second heat dissipation opening (127), and the third heat dissipation opening (128).

4. The display apparatus (100) of claim any one of claims 1 to 3, wherein:
the first control arm (141) comprises a locking pin (144) disposed on the first control arm (141) and configured to adjust a rotation angle of the first control arm (141); and
the control arm bracket (114) has a guide hole (115a) located at a surface portion of the control arm bracket (114) that contacts the first control arm (141) to correspond to the rotation angle of the first control arm (141) and configured to limit a movement of the locking pin (144).

5. The display apparatus (100) of claim 4, wherein the first control arm (141) further comprises a support bar (145) disposed on the first control arm (141) and adjacent to the locking pin (144), the support bar (145) configured to prevent the display module (110) from rotating by restricting rotating of the control arm bracket (114) when the display module (110) is pulled out from the housing (120) and in an open state.

6. The display apparatus (100) of any one of claims 1 to 5, further comprising an elastic member (150) coupled to the mover (140) and configured to provide auxiliary force to the mover (140), wherein the elastic member (150) comprises:
a first spring holder (151) disposed at an upper end of the storage space (123) and coupled to the main shaft (134) to rotate together with the main shaft (134);
a spiral spring (152) disposed within the first spring holder (151) and configured to rotate together with the main shaft (134); and
a second spring holder (153) fixed to the upper end of the storage space (123) and connected to the first spring holder (151) by the spiral spring (152).

7. The display apparatus of any one of claims 1 to 6, further comprising a position sensor (161) disposed adjacent to the first control arm (141) and the second control arm (147), wherein the position sensor (161) comprises:
a first switch (162) in contact with a first contact protrusion (141a) formed on a longitudinal end of the first control arm (141) and disposed adjacent to the first rotation axis on the position sensor (161); and
a second switch (163) in contact with a second contact protrusion (147a) formed a longitudinal end of the second control arm (147) and disposed adjacent to the second rotation axis on the position sensor (161).

8. A method for driving the display apparatus for the vehicle according to claim 1, **characterized in that** the method comprises:
a process (S61, S64) in which, when a first contact protrusion contacts a first switch and the first switch is turned on, and a second contact protrusion does not contact a second switch and the second switch is turned off, a motor is not driven and a display module is maintained in a closed state retracted into the housing;
a process (S62, S63, S65) in which, when an open signal is transmitted to the motor by a controller, the motor is driven to rotate a first control arm and a second control arm, the first contact protrusion does not contact the first switch, so that the first switch is turned off, and the second contact protrusion does not contact the second switch, so that the second switch is also turned off, thereby swinging the display module; and
a process (S66, S67, S68) in which, when the first contact protrusion does not contact the first switch, so that the first switch is turned off, and the second contact protrusion contacts the second switch, so that the second switch is turned on, the motor stops driving and the display module maintains an open state pulled out from the housing.

## Patentansprüche

1. Anzeigevorrichtung (100) für ein Fahrzeug, umfassend:
ein Anzeigemodul (110), das ein Anzeigefeld (111) umfasst, das zum Anzeigen eines Bilds eingerichtet ist;
ein Gehäuse (120), das benachbart zu dem Anzeigemodul (110) angeordnet ist und einen Aufnahmeraum aufweist;
eine Bewegungseinrichtung (140), die mit dem Anzeigemodul (110) verbunden und dazu eingerichtet ist, dieses zu bewegen;
eine Antriebseinheit (130), die in dem Aufnahmeraum des Gehäuses (120) angeordnet und dazu eingerichtet ist, der Bewegungseinrichtung (140) eine Antriebskraft bereitzustellen; und
eine Steuereinheit (160), die dazu eingerichtet ist, die Bewegungseinrichtung (140) und die Antriebseinheit (130) zu steuern,
wobei die Antriebseinheit (130) umfasst:
einen Motor (131), der benachbart zu der Bewegungseinrichtung (140) angeordnet und dazu eingerichtet ist, die Antriebskraft zu erzeugen;
ein Antriebszahnrad (133), das benachbart zu dem Motor (131) angeordnet und dazu eingerichtet ist, sich zu drehen, wenn die Antriebskraft von dem Motor (131) übertragen wird; und
eine Hauptwelle (134), die mit dem Antriebszahnrad (133) gekoppelt und dazu eingerichtet ist, sich zu drehen, wenn sich das Antriebszahnrad (133) dreht,
wobei das Anzeigemodul (110) dazu eingerichtet ist, in Bezug auf eine Längsachse der Hauptwelle (134) zu schwenken und zu schwingen, wenn sich die Hauptwelle (134) dreht,
**dadurch gekennzeichnet, dass**
die Bewegungseinrichtung (140) umfasst:
einen ersten Steuerarm (141), der zwischen einer mit dem Anzeigemodul (110) gekoppelten Steuerarmhalterung (114) und der Hauptwelle (134) verbunden und dazu eingerichtet ist, sich in Bezug auf eine erste Drehachse zu drehen, wenn sich die Hauptwelle (134) dreht; und
einen zweiten Steuerarm (147), der zwischen der Steuerarmhalterung (114) und einem mit dem ersten Steuerarm (141) gekoppelten Antriebsriemen (143) verbunden und dazu eingerichtet ist, sich in Bezug auf eine zweite Drehachse zu drehen, wenn eine Drehkraft der Hauptwelle (134) auf den Antriebsriemen (143) übertragen wird,
wobei das Anzeigemodul (110) dazu eingerichtet ist, in Bezug auf die Längsachse der Hauptwelle (134) zu schwingen, wenn sich der erste Steuerarm (141) und der zweite Steuerarm (147) drehen.

2. Anzeigevorrichtung (100) nach Anspruch 1, wobei:
das Gehäuse (120) einen Stauraumabschnitt (122) umfasst, der benachbart zu dem Anzeigemodul (110) angeordnet ist und einen Stauraum (123) sowie eine Öffnung aufweist, die den Stauraum (123) zur Außenseite des Gehäuses (120) freilegt,
der Stauraumabschnitt (122) an einer dem Anzeigemodul (110) zugewandten Oberfläche des Stauraumabschnitts (122) eine Bewegungsöffnung aufweist, die sich in einer Höhenrichtung des Anzeigemoduls (110) erstreckt, um eine Bewegung der Bewegungseinrichtung (140) zu ermöglichen, und
sich der Stauraum (123) in einer von der Höhenrichtung des Anzeigemoduls (110) verschiedenen Richtung erstreckt und in der Höhenrichtung von einem oberen Endabschnitt des Gehäuses (120) beabstandet ist.

3. Anzeigevorrichtung (100) nach Anspruch 2, wobei:
das Anzeigemodul (110) eine erste Wärmeableitungsöffnung (113) aufweist,
der Stauraumabschnitt (122) an einer rückwärtigen Oberfläche des Stauraums (123) des Stauraumabschnitts (122) eine zweite Wärmeableitungsöffnung (127) aufweist, wobei die zweite Wärmeableitungsöffnung (127) entsprechend der ersten Wärmeableitungsöffnung (113) angeordnet ist,
das Gehäuse (120) an einer rückwärtigen Oberfläche des Gehäuses (120) eine dritte Wärmeableitungsöffnung (128) aufweist, wobei die dritte Wärmeableitungsöffnung (128) entsprechend der zweiten Wärmeableitungsöffnung (127) angeordnet ist, und
sich ein Luftströmungsweg durch die erste Wärmeableitungsöffnung (113), die zweite Wärmeableitungsöffnung (127) und die dritte Wärmeableitungsöffnung (128) erstreckt.

4. Anzeigevorrichtung (100) nach einem der Ansprüche 1 bis 3, wobei:
der erste Steuerarm (141) einen Verriegelungsstift (144) umfasst, der an dem ersten Steuerarm (141) angeordnet und dazu eingerichtet ist, einen Drehwinkel des ersten Steuerarms (141) einzustellen; und
die Steuerarmhalterung (114) eine Führungsöffnung (115a) aufweist, die an einem Oberflächenabschnitt der Steuerarmhalterung (114), der den ersten Steuerarm (141) berührt, entsprechend dem Drehwinkel des ersten Steuerarms (141) angeordnet und dazu eingerichtet ist, eine Bewegung des Verriegelungsstifts (144) zu begrenzen.

5. Anzeigevorrichtung (100) nach Anspruch 4, wobei der erste Steuerarm (141) ferner eine Stützstange (145) umfasst, die an dem ersten Steuerarm (141) und benachbart zu dem Verriegelungsstift (144) angeordnet ist, wobei die Stützstange (145) dazu eingerichtet ist, eine Drehung des Anzeigemoduls (110) zu verhindern, indem sie eine Drehung der Steuerarmhalterung (114) begrenzt, wenn das Anzeigemodul (110) aus dem Gehäuse (120) herausgezogen ist und sich in einem geöffneten Zustand befindet.

6. Anzeigevorrichtung (100) nach einem der Ansprüche 1 bis 5, ferner umfassend ein elastisches Element (150), das mit der Bewegungseinrichtung (140) gekoppelt und dazu eingerichtet ist, der Bewegungseinrichtung (140) eine Hilfskraft bereitzustellen, wobei das elastische Element (150) umfasst:
einen ersten Federhalter (151), der an einem oberen Ende des Stauraums (123) angeordnet und mit der Hauptwelle (134) gekoppelt ist, um sich zusammen mit der Hauptwelle (134) zu drehen;
eine Spiralfeder (152), die innerhalb des ersten Federhalters (151) angeordnet und dazu eingerichtet ist, sich zusammen mit der Hauptwelle (134) zu drehen; und
einen zweiten Federhalter (153), der an dem oberen Ende des Stauraums (123) befestigt und durch die Spiralfeder (152) mit dem ersten Federhalter (151) verbunden ist.

7. Anzeigevorrichtung nach einem der Ansprüche 1 bis 6, ferner umfassend einen Positionssensor (161), der benachbart zu dem ersten Steuerarm (141) und dem zweiten Steuerarm (147) angeordnet ist, wobei der Positionssensor (161) umfasst:
einen ersten Schalter (162), der mit einem ersten Kontaktvorsprung (141a), der an einem Längsende des ersten Steuerarms (141) ausgebildet ist, in Kontakt steht und an dem Positionssensor (161) benachbart zu der ersten Drehachse angeordnet ist; und
einen zweiten Schalter (163), der mit einem zweiten Kontaktvorsprung (147a), der an einem Längsende des zweiten Steuerarms (147) ausgebildet ist, in Kontakt steht und an dem Positionssensor (161) benachbart zu der zweiten Drehachse angeordnet ist.

8. Verfahren zum Antreiben der Anzeigevorrichtung für das Fahrzeug nach Anspruch 1, **dadurch gekennzeichnet, dass** das Verfahren umfasst:
einen Vorgang (S61, S64), bei dem, wenn ein erster Kontaktvorsprung einen ersten Schalter berührt und der erste Schalter eingeschaltet ist und ein zweiter Kontaktvorsprung einen zweiten Schalter nicht berührt und der zweite Schalter ausgeschaltet ist, ein Motor nicht angetrieben wird und ein Anzeigemodul in einem in das Gehäuse eingezogenen geschlossenen Zustand gehalten wird;
einen Vorgang (S62, S63, S65), bei dem, wenn von einer Steuereinheit ein Öffnungssignal an den Motor übertragen wird, der Motor angetrieben wird, um einen ersten Steuerarm und einen zweiten Steuerarm zu drehen, der erste Kontaktvorsprung den ersten Schalter nicht berührt, sodass der erste Schalter ausgeschaltet wird, und der zweite Kontaktvorsprung den zweiten Schalter nicht berührt, sodass auch der zweite Schalter ausgeschaltet wird, wodurch das Anzeigemodul geschwungen wird; und
einen Vorgang (S66, S67, S68), bei dem, wenn der erste Kontaktvorsprung den ersten Schalter nicht berührt, sodass der erste Schalter ausgeschaltet ist, und der zweite Kontaktvorsprung den zweiten Schalter berührt, sodass der zweite Schalter eingeschaltet ist, der Motor den Antrieb einstellt und das Anzeigemodul einen aus dem Gehäuse herausgezogenen geöffneten Zustand beibehält.

## Revendications

1. Appareil d'affichage (100) pour un véhicule, comprenant:
un module d'affichage (110) comprenant un écran d'affichage (111) configuré pour afficher une image;
un boîtier (120) adjacent au module d'affichage (110) et comprenant un espace de logement;
un dispositif de déplacement (140) relié au module d'affichage (110) et conçu pour le déplacer;
une unité d'entraînement (130) disposée dans l'espace de logement du boîtier (120) et conçue pour fournir une force d'entraînement au dispositif de déplacement (140); et
un organe de commande (160) conçu pour commander le dispositif de déplacement (140) et l'unité d'entraînement (130),
dans lequel l'unité d'entraînement (130) comprend:
un moteur (131) disposé à proximité du dispositif de déplacement (140) et conçu pour générer la force d'entraînement;
un engrenage de transmission (133) disposé à proximité du moteur (131) et conçu pour tourner lorsque la force d'entraînement est transmise par le moteur (131); et
un arbre principal (134) couplé à l'engrenage d'entraînement (133) et conçu pour tourner lorsque l'engrenage de transmission (133) tourne,
dans lequel le module d'affichage (110) est configuré pour pivoter et osciller par rapport à un axe longitudinal de l'arbre principal (134) lorsque l'arbre principal (134) tourne,
**caractérisé en ce que**
le dispositif de déplacement (140) comprend:
un premier bras de commande (141) relié entre un support de bras de commande (114) couplé au module d'affichage (110) et l'arbre principal (134), et configuré pour tourner par rapport à un premier axe de rotation lorsque l'arbre principal (134) tourne; et
un deuxième bras de commande (147) relié entre le support de bras de commande (114) et une courroie d'entraînement (143) couplée au premier bras de commande (141), et conçu pour tourner par rapport à un deuxième axe de rotation lorsqu'une force de rotation de l'arbre principal (134) est transmise à la courroie d'entraînement (143),
dans lequel le module d'affichage (110) est configuré pour pivoter par rapport à l'axe longitudinal de l'arbre principal (134) lorsque le premier bras de commande (141) et le deuxième bras de commande (147) tournent.

2. Appareil d'affichage (100) selon la revendication 1, dans lequel:
le boîtier (120) comprend une partie de rangement (122) disposée à proximité du module d'affichage (110) et comportant un espace de rangement (123) ainsi qu'une ouverture rendant visible l'espace de rangement (123) à l'extérieur du boîtier (120),
la partie de rangement (122) comporte un orifice de déplacement situé sur une surface de la partie de rangement (122) faisant face au module d'affichage (110) et s'étendant dans le sens de la hauteur du module d'affichage (110) afin de permettre au dispositif de déplacement (140) de se déplacer, et
l'espace de rangement (123) s'étend dans une direction différente de la direction verticale du module d'affichage (110) et est espacé d'une partie d'extrémité supérieure du boîtier (120) dans la direction verticale.

3. Appareil d'affichage (100) selon la revendication 2, dans lequel:
le module d'affichage (110) comporte une première ouverture de dissipation thermique (113),
la partie de rangement (122) comporte une deuxième ouverture de dissipation thermique (127) située sur une face arrière de l'espace de rangement (123) de la partie de rangement (122), la deuxième ouverture de dissipation thermique (127) étant disposée en correspondance avec la première ouverture de dissipation thermique (113),
le boîtier (120) comporte une troisième ouverture de dissipation thermique (128) au niveau d'une surface arrière du boîtier (120), la troisième ouverture de dissipation thermique (128) étant disposée en correspondance avec la deuxième ouverture de dissipation thermique (127), et
un chemin d'écoulement d'air s'étend à travers la première ouverture de dissipation thermique (113), la deuxième ouverture de dissipation thermique (127) et la troisième ouverture de dissipation thermique (128).

4. Appareil d'affichage (100) selon l'une quelconque des revendications 1 à 3, dans lequel:
le premier bras de commande (141) comprend une goupille de verrouillage (144) disposée sur le premier bras de commande (141) et conçue pour régler un angle de rotation du premier bras de commande (141); et
le support de bras de commande (114) comporte un trou de guidage (115a) situé au niveau d'une partie de surface du support de bras de commande (114) qui est en contact avec le premier bras de commande (141), de manière à correspondre à l'angle de rotation du premier bras de commande (141) et à limiter le mouvement de la goupille de verrouillage (144).

5. Appareil d'affichage (100) selon la revendication 4, dans lequel le premier bras de commande (141) comprend en outre une barre de support (145) disposée sur le premier bras de commande (141) et adjacente à la goupille de verrouillage (144), la barre de support (145) étant conçue pour empêcher le module d'affichage (110) de tourner en limitant la rotation du support de bras de commande (114) lorsque le module d'affichage (110) est sorti du boîtier (120) et se trouve en position ouverte.

6. Appareil d'affichage (100) selon l'une quelconque des revendications 1 à 5, comprenant en outre un élément élastique (150) relié au dispositif de déplacement (140) et conçu pour fournir une force auxiliaire à l'organe de déplacement (140), l'élément élastique (150) comprenant:
un premier support de ressort (151) disposé à l'extrémité supérieure de l'espace de rangement (123) et relié à l'arbre principal (134) de manière à tourner conjointement avec l'arbre principal (134);
un ressort hélicoïdal (152) disposé à l'intérieur du premier support de ressort (151) et conçu pour tourner conjointement avec l'arbre principal (134); et
un deuxième support de ressort (153) fixé à l'extrémité supérieure de l'espace de rangement (123) et relié au premier support de ressort (151) par le ressort hélicoïdal (152).

7. Appareil d'affichage (100) selon l'une quelconque des revendications 1 à 6, comprenant en outre un capteur de position (161) disposé à proximité du premier bras de commande (141) et du deuxième bras de commande (147), le capteur de position (161) comprenant:
un premier interrupteur (162) en contact avec une première saillie de contact (141a) formée sur une extrémité longitudinale du premier bras de commande (141) et disposée à proximité du premier axe de rotation sur le capteur de position (161); et
un deuxième interrupteur (163) en contact avec une deuxième saillie de contact (147a) formée à l'extrémité longitudinale du deuxième bras de commande (147) et disposée à proximité du deuxième axe de rotation sur le capteur de position (161).

8. Procédé d'entraînement de l'appareil d'affichage pour le véhicule selon la revendication 1, **caractérisé en ce que** le procédé comprend:
un processus (S61, S64) dans lequel, lorsqu'une première saillie de contact entre en contact avec un premier interrupteur et que le premier interrupteur est allumé, et qu'une deuxième saillie de contact n'entre pas en contact avec un deuxième interrupteur et que le deuxième interrupteur est éteint, le moteur n'est pas entraîné et le module d'affichage reste dans un état fermé, rétracté à l'intérieur du boîtier;
un processus (S62, S63, S65) dans lequel, lorsqu'un signal d'ouverture est transmis au moteur par un organe de commande, le moteur est entraîné pour faire tourner un premier bras de commande et un deuxième bras de commande, la première saillie de contact n'entre pas en contact avec le premier interrupteur, de sorte que le premier interrupteur est éteint, et la deuxième saillie de contact n'entre pas en contact avec le deuxième interrupteur, de sorte que le deuxième interrupteur est également éteint, ce qui fait basculer le module d'affichage; et
un processus (S66, S67, S68) dans lequel, lorsque la première saillie de contact n'est pas en contact avec le premier interrupteur, de sorte que le premier interrupteur est éteint, et que la deuxième saillie de contact est en contact avec le deuxième interrupteur, de sorte que le deuxième interrupteur est allumé, le moteur cesse l'entraînement et le module d'affichage reste dans un état ouvert, sorti de son boîtier.
